# EUROPEAN PATENT APPLICATION

(11) **EP 2 743 625 A1**
(43) Date of publication of application: **18.06.2014**
(21) Application number: 13196207.8
(22) Date of filing: 09.12.2013
(51) Int. Cl.: F28F 1/22, F28F 1/32

(54) **Water cooling apparatus**

(30) Priority: 12.12.2012 KR 20120144763
(71) Applicant: Zalman Tech Co., Ltd., Gumchun-gu, Seoul 153-803 (KR)
(72) Inventor: Park, Sang Woong, Gyeonggi-do 441-762 (KR); Kim, Do Hyun, Seoul 140-170 (KR); Lee, Hyun Woo, Seoul 156-765 (KR)
(74) Representative: Boult Wade Tennant

(57) **Abstract**

A water cooling apparatus (1) is disposed outside an electronic apparatus (100) equipped with a heat generating part to cool heat generated from the heat generating part by using a coolant. The water cooling apparatus (1) includes a plurality of hollow tubes (21) through which the coolant receiving the heat of the heat generating part flows to be cooled. Each hollow tube (21) is formed in a shape of a quadratic curve. The water cooling apparatus (1) further includes at least one radiator (20) that includes a plurality of heat dissipation fins (21) coupled to the plurality of hollow tubes (21) and arranged to be separated from each other along the plurality of hollow tubes (21).

## Description

### BACKGROUND

### 1. Field

One or more embodiments of the present invention relate to a water cooling apparatus, and more particularly, to a water cooling apparatus disposed outside an electronic apparatus equipped with heat generating parts and having a radiator having an improved structure so as to cool heat generated from the heat generating parts by using a circulating coolant, thereby achieving high cooling performance and lightness.

### 2. Description of the Related Art

A typical water cooling apparatus uses water or a coolant (cooling water) obtained by adding a chemical component such as anti-corrosion agent to water, to cool heat generating parts, for example, CPU, a chipset, RAM, or FET, provided in an electronic apparatus such as a computer and generating heat. A water cooling apparatus generally includes a water block, a radiator, a fan, a pump, a water tank, a controller, etc.

The water block having a lower surface contacting with an upper surface of a heat generating part receives heat generated from the heat generating part and makes heat exchange with a coolant. The radiator receives heat from the coolant and dissipates the heat to the outside so as to cool the coolant. The pump circulates the coolant filling the water tank, the radiator, and tubes. The fan blows external air toward the radiator to facilitate cooling. The controller controls an operation of the fan or the pump.

The above-described background technology is technical information kept by the present inventor to invent the present invention or obtained by the present inventor while inventing the present invention, which cannot be said to be necessarily well-known technology open to the public before filing of the present application.

### SUMMARY

One or more embodiments of the present invention include a water cooling apparatus having an improved structure of a radiator so that cooling performance may be improved and lightness may be achieved.

Additional aspects will be set forth in part in the description which follows and, in part, will be apparent from the description, or may be learned by practice of the presented embodiments.

According to one or more embodiments of the present invention, a water cooling apparatus disposed outside an electronic apparatus equipped with a heat generating part and cooling heat generated from the heat generating part by using a coolant, includes a plurality of hollow tubes through which the coolant receiving the heat of the heat generating part flows to be cooled, each of the plurality of hollow tubes being formed in a shape of a quadratic curve, and at least one radiator including a plurality of heat dissipation fins coupled to the plurality of hollow tubes and arranged to be separated from each other along the plurality of hollow tubes.

The plurality of hollow tubes may be formed in a loop or circular shape.

The plurality of hollow tubes in shapes of quadratic curves having different diameters may be coaxially and parallelly arranged.

The plurality of hollow tubes may be parallelly arranged in an axial direction of the quadratic curve.

The plurality of heat dissipation fins may be radially arranged along the plurality of hollow tubes.

The plurality of heat generation fins that are radially arranged may be formed such that at least a part of a portion adjacent to the center axis direction of the plurality of heat generation fins is removed.

The coolant may include at least one of water, ethylene glycol (EG), propylene glycol (PG), and a nano liquid.

The water cooling apparatus may further include a case accommodating the radiator therein and having a plurality of partitions, a fan provided in the case to flow external air into an inner space of the case and exhaust the external air outside the case, a pump provided at one side of the inner space of the case and circulating the coolant between the radiator and a water block coupled to the heat generation part of the electronic apparatus, and a controller controlling operations of the fan and the pump.

### BRIEF DESCRIPTION OF THE DRAWINGS

These and/or other aspects will become apparent and more readily appreciated from the following description of the embodiments, taken in conjunction with the accompanying drawings in which:
FIG. 1 is a perspective view illustrating that a water cooling apparatus according to an embodiment of the present invention is installed at a computer;
FIG. 2 is a perspective view of the water cooling apparatus of FIG. 1;
FIG. 3 is a side view of the water cooling apparatus of FIG. 1; and
FIG. 4 is a front view of the water cooling apparatus of FIG. 1.

### DETAILED DESCRIPTION

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects of the present description. As used herein, the term "and/or" includes any and all combinations of one or more of the associated listed items. Expressions such as "at least one of," when preceding a list of elements, modify the entire list of elements and do not modify the individual elements of the list.

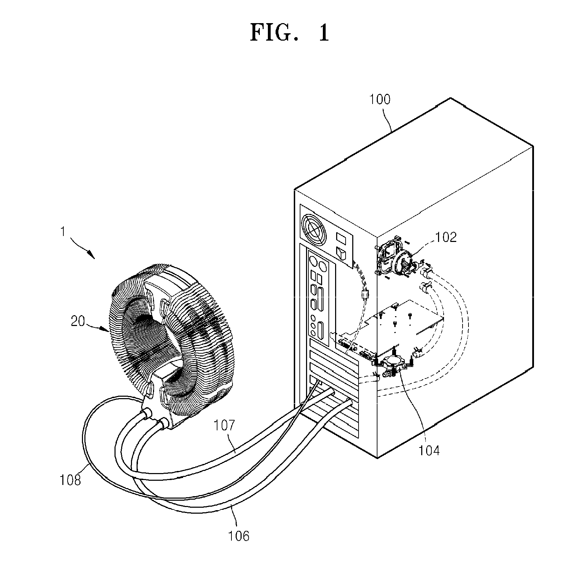

FIG. 1 is a perspective view illustrating that a water cooling apparatus 1 according to an embodiment of the present invention is installed at a computer 100. Referring to FIG. 1, the water cooling apparatus 1 according to the present embodiment cools heat of a heat generating part installed in an electronic apparatus (not shown), for example, the computer 100, and generating heat during operation, by using a circulating liquid coolant. For a computer, the heat generating part may be a central processing unit (CPU), a main chipset mounted on a graphics card, RAM, etc.

In FIG. 1, the water cooling apparatus 1 according to the present embodiment is installed at the computer 100 that is an example of the electronic apparatus. The water cooling apparatus 1 is connected to a water block 102 coupled to the CPU and a water block 104 coupled to the main chipset of a graphics card to cool the CPU and the main chipset that are heat generating parts provided in the computer 100.

The water cooling apparatus 1 supplies a coolant to the water blocks 102 and 104 coupled to heat generating parts through a supply tube 106 to receive heat from the heat generating parts and receives the coolant through a return tube 107 to cool the coolant and supply the cooled coolant to the water blocks 102 and 104 again. By repeating the above operations, the heat generating parts are cooled down. A base inside each of the water blocks 102 and 104 is formed in a micro-fin method so that the maximum heat dissipation area may be secured and thus cooling performance may be improved. Also, the water blocks 102 and 104 may include a low-noise, high-performance pump (not shown) in each of the water blocks 102 and 104 to control a flow rate of the coolant moving toward a radiator 20 and reduce noise during operation of the pump.

In the water cooling apparatus 1 according to the present embodiment, although a water block coupled to a heat generating part is one of essential elements in a water cooling system, it is assumed in the present specification that the water block is not included as an element of the water cooling apparatus 1 according to the present embodiment. The water block is provided appropriate for the type and shape of a heat generating part provided in the electronic apparatus and is coupled to the water cooling apparatus 1 according to the present embodiment by the supply tube 106, forming a water cooling system.

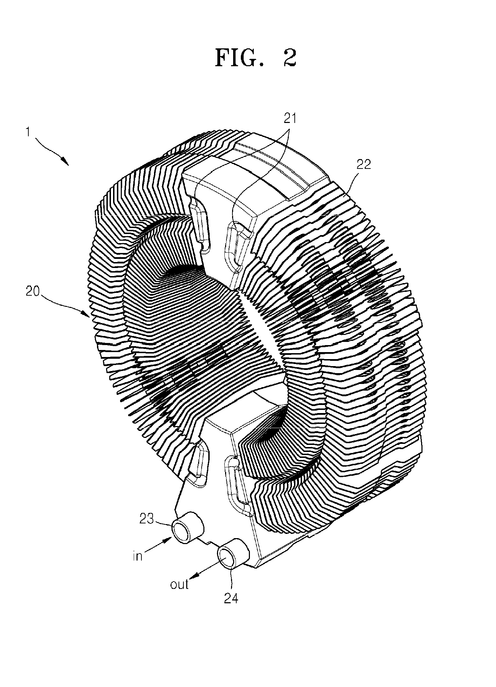

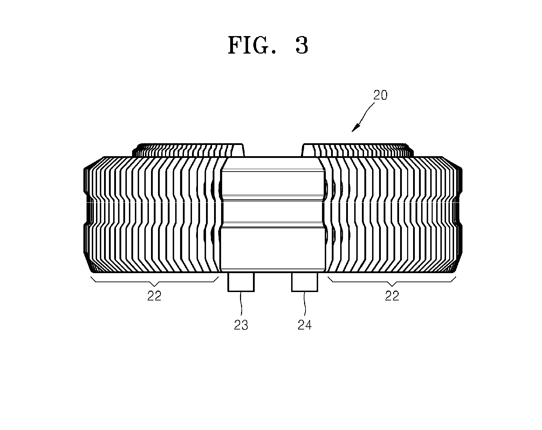

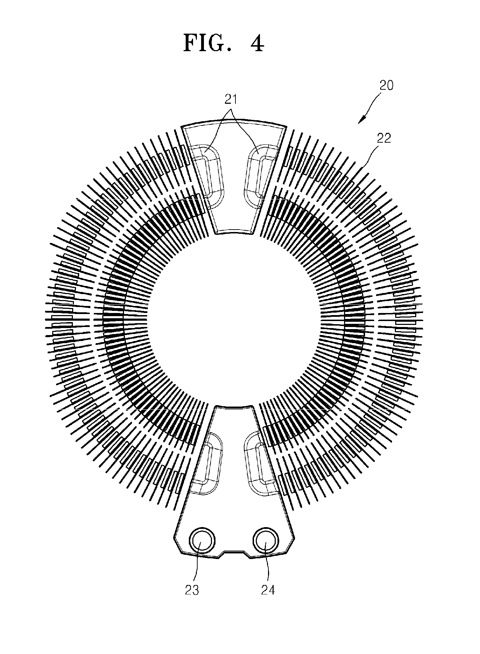

FIG. 2 is a perspective view of the water cooling apparatus 1 of FIG. 1. FIG. 3 is a side view of the water cooling apparatus 1 of FIG. 1. FIG. 4 is a front view of the water cooling apparatus 1 of FIG. 1.

Referring to FIGS. 2, 3, and 4, the water cooling apparatus 1 according to the present embodiment includes the radiator 20 and further includes a case, a fan, a pump, and a controller, which will be described below in detail.

A general water cooling system for cooling a heat generating part by using a cooling water or other fluids uses a radiator adopting a louver fin or an integrated heat sink formed of a metal material exhibiting superior thermal conductivity, such as aluminum (Al), copper (Cu), etc. For the integrated heat sink, since a pump is generally included in a radiator, noise is relatively severe and the size of the radiator increases due to difficulty in securing a heat dissipation area. For the radiator adopting a louver fin, since smooth circulation of a coolant and an appropriate heat dissipation area both are secured, a coolant path may have a rectangular structure of a radiator that is parallelly unified. To improve cooling performance, the heat dissipation area is increased so that the size of the radiator becomes large like the integrated heat sink.

To address the above issues, in the water cooling apparatus 1 according to the present embodiment, like a structure of a heat sink of an air-cooling cooler having optimal cooling performance, a hollow tube is arranged in a looped or circular shape forming a heat path and heat dissipation fins are radially arranged outside the hollow tube so that not only main heat generating parts to which water blocks are coupled but also peripheral heat generating parts around the radiator may be cooled, thereby improving a cooling efficiency.

In detail, the radiator 20 performs cooling of a coolant heated by the heat generating part. The radiator 20 includes a plurality of heat dissipation fins 22, each having a shape of a thin metal plate, and a plurality of hollow tubes 21 coupled to the heat dissipation fins 22 by penetrating the cooling fins 22 several times. As the heat of the coolant flowing through the hollow tubes 21 is transferred to the heat dissipation fins 22 and then cooled by the wind blown by the fan.

The hollow tubes 21 receive again the heat which is transferred to the water cooling apparatus 1 from the electronic apparatus, and transfer the heat to the heat dissipation fins 22 which will be described later. In the present embodiment, the hollow tubes 21, which are referred to heat transfer tubes, absorb heat of a portion of the computer 100 of FIG. 1 having a relatively high temperature and transfer the heat to a portion of the computer 100 of FIG. 1 having a relatively low temperature. Also, since the heat is also dissipated into the air from the hollow tubes 21 while transferring the heat, the hollow tubes 21 simultaneously perform a heat cooling function. The hollow tubes 21 each may be formed into a cylindrical pipe member.

Each of the hollow tubes 21 may have a shape of a quadratic curve such as a loop or circular shape (circle, ellipse, parabola, hyperbola, etc.). The "quadratic curve" shape does not necessarily signify a complete circle according to a mathematical definition or an arc shape as part of the quadratic curve, but it signifies a shape that may be recognized by an ordinary person to be a circle or an arc, or a bent shape corresponding to a circle or an arc, as a whole. In other words, the hollow tubes 21 each may schematically or substantially have a ring, loop, or circular shape.

In FIGS. 2 to 4, the hollow tubes 21, each having a different diameter in a semicircular shape, are arranged coaxially and parallelly to be connected each other. Also, two rows of the hollow tubes 21 are arranged parallel to each other in an axial direction. As the hollow tubes 21 are arranged in a dual radial form, the water cooling apparatus 1 is appropriate for a natural convection environment and performance of the heat sink in a forced convection type using a low-noise cooling fan may be much improved. However, the technical concept of the present invention is not limited thereto and the shape, arrangement, and number of the hollow tubes 21 may vary according to the shape and heat dissipation ability required by a cooling apparatus.

Each of the heat dissipation fins 22 is formed of metal exhibiting relatively superior heat conductivity, such as copper (Cu) or aluminum (Al), into a thin plate. The heat dissipation fins 22 are coupled to the hollow tubes 21 to be separated from each other along the hollow tubes 21. In the present embodiment in which the hollow tubes 21 are formed to have quadratic curves such as a loop or circular shape, the heat dissipation fins 22 are arranged to the hollow tubes 21 forming a radial shape. The outer shape of the heat dissipation fins 22 is substantially in the form of a quadratic curve such as a loop or circular shape. Each of the heat dissipation fins 22 has a through hole (not shown). The number of through holes is the same as or more than that of the hollow tubes 21 coupled to the heat dissipation fins 22. The hollow tubes 21 penetrate through the through holes to be coupled to the heat dissipation fins 22.

The heat dissipation fins 22 may be formed of a radial type in a connection structure of a single sheet or hinge type. Each of the heat dissipation fins 22 is formed by removing an inner space of the radiator 20 where air flow is relatively low and forming a heat dissipation fin at an outer portion of the radiator 20 where a convention influence is large, thereby forming a light heat sink.

As such, in the radiator 20 according to the present embodiment, since the hollow tubes 21 formed of a metal material, such as Cu, Al, etc., are provided in a circular shape forming a thermal path and the heat dissipation fins 22 are radially arranged outside the hollow tubes 21, the heat of the main heat generating parts transferred through the water blocks 102 and 104 may be dissipated and further the heat of the peripheral heat generating parts where the radiator 20 is installed may be dissipated.

In the radiator 20 having a loop or circular shape, the thermal path in the radiator 20 may be additionally provided serially or parallelly and thus heat transfer efficiency may be improved. Also, since the radiator 20 has a circular heat sink structure like the cooling fan, the radiator 20 is appropriate for air flow and has an effect of reducing an unnecessary heat dissipation area.

The water cooling apparatus 1 is a water cooling heat exchange apparatus for efficiently transferring heat by using a cooling water or a coolant filling the inside of the hollow tubes 21. The coolant filling the inside of the water cooling apparatus 1 may be at least one selected from cooling water (100% pure water), ethylene glycol (EG), propylene glycol (PG), and a nano liquid that does not corrode metal.

Although it is not illustrated in the drawings, the water cooling apparatus 1 according to the present embodiment may further include the case, the fan, the pump, and the controller, as described above.

The case may have a plurality of partitions to accommodate the radiator 20 therein. An air ventilation hole through which relatively cold air outside the case may flow in an inner space of the case may be provided at least one of the partitions.

The fan may be installed to allow external air to enter the inner space of the case and then exit outside the case. In other words, the fan rotates to exhaust the air inside the case to the outside. In detail, when the fan is operated to exhaust the air inside the case to the outside, the pressure in the case decreases and thus the air outside the case, which is relatively cold, is flown in through the through hole in the case. In doing so, heat exchange occurs between the coolant and the cold air in the radiator 20 installed inside the air ventilation hole and thus the temperature of the coolant may be lowered.

The pump is provided in the inner space of the case and circulates the coolant between the radiator 20 and the water blocks 102 and 104 that are coupled to the heat generating parts of the electronic apparatus. Also, according to the operation of the pump, the coolant flows into the water cooling apparatus 1 from the water blocks 102 and 104 and passes through the radiator 20 and circulates toward the water blocks 102 and 104 outside the water cooling apparatus 1. The power needed to operate the fan and the pump may be supplied from the computer 100 through an electric wire 108.

The controller may control the operations of the fan and the pump, that is, the rotation speed of the fan or the revolutions per minute (RPM) of the pump. Since the function of the controller is well known technology in the technical field to which the present invention pertains, a detailed description on the structure of the controller will be omitted herein.

The method of manufacturing the water cooling apparatus 1 according to the present embodiment will be described below in detail.

First, a base (not shown) in each of the water blocks 102 and 104 contacting the heat generating parts such as a CPU or a main chipset of a graphics card inside the computer 100 is skiving-processed to form micro-fins to secure a heat dissipation area as large as possible. The water pump is provided directly above the base (OK) and a combination portion of the base and the water pump where the cooling water exists is sealed with a rubber gasket, thereby manufacturing a pump module (not shown).

The radiator 20 of the water cooling apparatus 1 is configured into an inside/outside radial, dual heat sink by fixing the heat dissipation fins 22 to the hollow tubes 21 formed of a metal material such as Cu or Al in a method of forcibly inserting or adhering the heat dissipation fins 22 to the hollow tubes 21 using a brazing filler wire, and then bending the hollow tubes 21 in a loop or circular shape according to the size of a product.

Inlet and outlet 23 and 24 of water paths of the hollow tubes 21 of a circularly bent radial, dual heat sink are sealed by brazing to be connected to a reservoir (not shown) located at the center of the radiator 20.

Next, the reservoir of the radiator 20 and inlet/outlet of the pump module of the water blocks 102 and 104 are connected to each other by using the supply tube 106 and the return tube 107. When the of the supply tube 106 is made vacuum, the coolant selected from cooling water (100% pure water), ethylene glycol (EG), propylene glycol (PG), and a nano liquid that does not corrode metal fills the radiator 20 and the water blocks 102 and 104.

Next, after air remaining in the radiator 20 and the water blocks 102 and 104 is removed by adjusting a fastening screw of an air exhaust hole provided in the pump module of the water blocks 102 and 104, a product test is performed by completing a leakage test.

As described above, according to the one or more of the above embodiments of the present invention, since the structure of the radiator is changed as above, cooling performance may be improved and lightness is achieved.

It should be understood that the exemplary embodiments described therein should be considered in a descriptive sense only and not for purposes of limitation. Descriptions of features or aspects within each embodiment should typically be considered as available for other similar features or aspects in other embodiments. While one or more embodiments of the present invention have been described with reference to the figures, it will be understood by those of ordinary skill in the art that various changes in form and details may be made therein without departing from the spirit and scope of the present invention as defined by the following claims.

## Claims

1. A water cooling apparatus disposed outside an electronic apparatus equipped with a heat generating part and cooling heat generated from the heat generating part by using a coolant, the water cooling apparatus comprising:
a plurality of hollow tubes through which the coolant receiving the heat of the heat generating part flows to be cooled, each of the plurality of hollow tubes being formed in a shape of a quadratic curve; and
at least one radiator comprising a plurality of heat dissipation fins coupled to the plurality of hollow tubes and arranged to be separated from each other along the plurality of hollow tubes.

2. The water cooling apparatus of claim 1, wherein the plurality of hollow tubes are formed in a loop or circular shape.

3. The water cooling apparatus of claim 1, wherein the plurality of hollow tubes in shapes of quadratic curves having different diameters are coaxially and parallelly arranged.

4. The water cooling apparatus of claim 1, wherein the plurality of hollow tubes are parallelly arranged in an axial direction of the quadratic curve.

5. The water cooling apparatus of claim 1, wherein the plurality of heat dissipation fins are radially arranged along the plurality of hollow tubes.

6. The water cooling apparatus of claim 5, wherein the plurality of heat generation fins that are radially arranged are formed such that at least a part of a portion adjacent to the center axis direction of the plurality of heat generation fins is removed.

7. The water cooling apparatus of claim 1, wherein the coolant comprises at least one of water, ethylene glycol (EG), propylene glycol (PG), and a nano liquid.

8. The water cooling apparatus of claim 1, further comprising:
a case accommodating the radiator therein and having a plurality of partitions;
a fan provided in the case to flow external air into an inner space of the case and exhaust the external air outside the case;
a pump provided at one side of the inner space of the case and circulating the coolant between the radiator and a water block coupled to the heat generation part of the electronic apparatus; and
a controller controlling operations of the fan and the pump.
